# EUROPEAN PATENT APPLICATION

(11) **EP 4 761 022 A1**
(43) Date of publication of application: **17.06.2026**
(21) Application number: 25221671.8
(22) Date of filing: 09.12.2025
(51) Int. Cl.: H02B 1/56, H01M 10/613

(54) **HIGH-VOLTAGE BOX AND ENERGY STORAGE CONTAINER**

(30) Priority: 10.12.2024 CN 202423045154 U
(71) Applicant: AESC Japan Ltd., Yokohama-shi, Kanagawa 220-0012 (JP)
(72) Inventor: CHEN, Siyi, Pudong New Area Shanghai, 201315 (CN); FU, Yundi, Pudong New Area Shanghai, 201315 (CN)
(74) Representative: Becker, Eberhard

(57) **Abstract**

A high-voltage box and an energy storage container are provided. The high-voltage box includes: multiple electrical components (100); multiple conductive components (200), each having a first panel surface (210) including a first region (211) and a second panel surface (220) disposed opposite to each other along a first direction; multiple semiconductor cooling components (300), each including a cooling end (310) for absorbing heat. Each conductive component (200) is electrically connected with the corresponding electrical component (100) through the first region (211). The cooling ends (310) are thermally connected with the conductive components (200) through the second panel surfaces (220). Along the first direction, an orthogonal projection of each cooling end (310) on the corresponding first panel surface (210) at least partially overlaps with of the first region (211).

## Description

### BACKGROUND

### Technical Field

The present disclosure relates to energy storage technology, and particularly relates to a high-voltage box and an energy storage container.

### Description of Related Art

Energy storage technology has been developed rapidly and become a crucial support for energy transition and sustainable development. With continuous technological advancements, batteries used for energy storage now possess higher energy density, longer lifespan, and lower costs. This also implies that the battery capacity is greater, and the current passing through electrical equipment is higher. To ensure the normal operation of energy storage systems, there are heightened requirements for thermal dissipation and heat resistance performance of electrical equipment within storage containers.

A high-voltage box is a significant component within an energy storage container, containing various electrical components that ensure safe and reliable operation of the energy storage system. During system operation, when a circuit is connected, electrical components generate heat while functioning, necessitating timely dissipation of this heat. In related technologies, method for cooling the high-voltage box is natural cooling. As energy storage technology advances, the current passing through the high-voltage box increases, rendering the natural cooling method insufficient to meet the cooling demands of the high-voltage box.

### SUMMARY

In view of the foregoing, the purpose of the present disclosure is to provide a high-voltage box and an energy storage container, aimed at least partially addressing the issue wherein natural cooling methods fail to meet the cooling requirements of the high-voltage box.

Based on the above purpose, a first aspect of the present disclosure provides a high-voltage box includes: multiple electrical components; multiple conductive components, each having a first panel surface including a first region and a second panel surface disposed opposite to each other along a first direction; multiple semiconductor cooling components, each including a cooling end for absorbing heat. Each conductive component is electrically connected with the corresponding electrical component through the first region. The cooling ends are thermally connected with the conductive components through the second panel surfaces. Along the first direction, an orthogonal projection of each cooling end on the corresponding first panel surface at least partially overlaps with of the first region.

Optionally, each semiconductor cooling component further includes a hot end for dissipating heat. The hot end is thermally connected with a first active heat dissipation component.

Optionally, a heat dissipation component is further connected between each hot end and the corresponding first active heat dissipation component.

Optionally, each heat dissipation component includes a heat conducting body and multiple heat dissipation fins. The heat conducting body has a first heat conducting surface and a second heat conducting surface. The first heat conducting surface is thermally connected with the hot end. The multiple heat dissipation fins are thermally connected to the second heat conducting surface arranged at intervals. Each first active heat dissipation component is connected to a side of the corresponding heat dissipation fin away from the second heat conducting surface.

Optionally, when at least two of the hot ends have surfaces that are adjacent to each other and located on the same plane, at least two of the surfaces are thermally connected to the same first heat conducting surface.

Optionally, along the first direction, the orthogonal projection of each cooling end on the corresponding first panel surface covers the first region.

Optionally, at least part of the conductive components are provided with at least two stacked layers arranged at intervals along the first direction. An insulating support component is disposed between two of the conductive components adjacent to each other along the first direction.

Optionally, the high-voltage box includes a housing. The electrical components, the conductive components, and the semiconductor cooling components are disposed within the housing. A side wall of the housing is provided with a through ventilation hole and a mounting through hole. A second active heat dissipation component is connected in the mounting through hole. At least one of the conductive components is close to the side wall of the housing and extend along the side wall of the housing.

Optionally, the high-voltage box includes the first active heat dissipation component. At least one of the first active heat dissipation component and the second active heat dissipation component includes a fan.

Optionally, the high-voltage box includes the housing. The housing includes a panel. The panel is connected with multiple electrical interfaces. Each conductive component is electrically connected with the corresponding electrical interface. The panel is further connected with at least one cooling electrical interface. The semiconductor cooling components are electrically connected with the cooling electrical interface.

Optionally, the conductive components include a solid structure formed by a conductive material.

Optionally, each electrical components include at least one of a pre-charge resistor, a pre-charge relay, a fuse, a high-voltage relay, a switching-mode power supply relay, a switching-mode power supply, an isolation switch, a current sensor, and a shunt.

Based on the same inventive concept, a second aspect of the present disclosure also provides an energy storage container, including: an energy storage cluster, an energy storage converter, and the high-voltage box as described in the first aspect. The high-voltage box is electrically connected with the energy storage cluster and the energy storage converter respectively.

In view of the aforementioned description, it is evident that the high-voltage box and the energy storage container provided by the present disclosure leverage the advantages of the semiconductor cooling component, which include compact size, compact structure, absence of mechanical moving parts, minimal spatial and shape constraints, and high reliability. The design of the present disclosure allows for the thermal conductive connection of the cooling end of the semiconductor cooling component to the surfaces of the conductive components, ensuring that the cooling end covers at least a portion of the first region where the conductive components are electrically connected to the electrical components. The semiconductor cooling component may directly convert electrical energy into cooling energy with minimal thermal inertia, enabling rapid cooling of the conductive components. This design ensures that the electrical components may operate safely at an appropriate temperature, thereby enhancing the working efficiency and stability of the high-voltage box and improving the overall operational efficiency of the energy storage system that includes the high-voltage box, while ensuring the operational safety of the system.

### BRIEF DESCRIPTION OF THE DRAWINGS

To provide a clearer explanation of the technical solutions within the present disclosure or related technology, a brief introduction to the drawings required in the description of embodiments or related technology is provided below. It is evident that the drawings described below are merely embodiments of the present disclosure. For those skilled in the art, without engaging in inventive labor, other drawings may also be derived from these drawings.
FIG. 1 is a perspective view of a high-voltage box with a first structure according to an example of the present disclosure.
FIG. 2 is an exploded view of a high-voltage box with a first structure according to an example of the present disclosure.
FIG. 3 is a partial perspective view of a high-voltage box according to an example of the present disclosure.
FIG. 4 is a partial side view of a high-voltage box according to an example of the present disclosure.
FIG. 5 is a structural principle diagram of a semiconductor cooling panel according to an example of the present disclosure.
FIG. 6 is a schematic diagram of FIG. 3 after removing a first active heat dissipation component and a heat dissipation component.
FIG. 7 is a right-side view of a high-voltage box according to an example of the present disclosure.
FIG. 8 is a left-side view of a high-voltage box according to an example of the present disclosure.
FIG. 9 is a front view of a panel of a high-voltage box with a first structure according to an example of the present disclosure.
FIG. 10 is an exploded perspective view of a high-voltage box with a second structure according to an example of the present disclosure.
FIG. 11 is a rear perspective view of a panel of a high-voltage box with a second structure according to an example of the present disclosure.
FIG. 12 is a diagram showing a connection between a semiconductor cooling component and a cooling wire of a high-voltage box according to an example of the present disclosure.

### DESCRIPTION OF THE EMBODIMENTS

To make the purpose, technical solutions and advantages of the present disclosure clearer, the present disclosure is further described in detail below in combination with specific examples and with reference to the accompanying drawings.

It should be noted that: unless otherwise specifically stated, the relative arrangement of components, numerical expressions and numerical values set forth in these examples do not limit the scope of the present disclosure.

Meanwhile, it should be understood that, for convenience of description, the dimensions of various parts shown in the drawings are not drawn according to actual proportional relationships.

The following description of at least one exemplary example is actually merely illustrative and in no way serves as any limitation on the present disclosure and its application or use.

It should be noted that, unless otherwise defined, technical terms or scientific terms used in the examples of the present disclosure should have the usual meanings understood by persons having ordinary skill in the field to which the present disclosure belongs. "First", "second" and similar words used in the examples of the present disclosure do not indicate any order, quantity or importance, but are only used to distinguish different components. "Include" or "contain" and similar words mean that the components or objects appearing before the word cover the components or objects listed after the word and their equivalents, without excluding other components or objects. "Connect" or "connected" and similar words are not limited to physical or mechanical connections, but may include electrical connections, whether direct or indirect. "Upper", "lower", "left", "right" and the like are only used to indicate relative positional relationships, and when the absolute position of the described object changes, the relative positional relationship may also change correspondingly.

In some examples, the high-voltage box is cooled through a fan-forced cooling method.

However, the fan-forced cooling method has high requirements for selection of fans and installation positions. If the fan is improperly arranged, a wind flow on component surfaces inside the high-voltage box might be uneven, and local cooling effect for current-carrying components might be poor. In extreme cases, localized dead zones may form within the high-voltage box, where components cannot be adequately cooled. This situation poses a risk of overheating, which may lead to safety incidents such as fires.

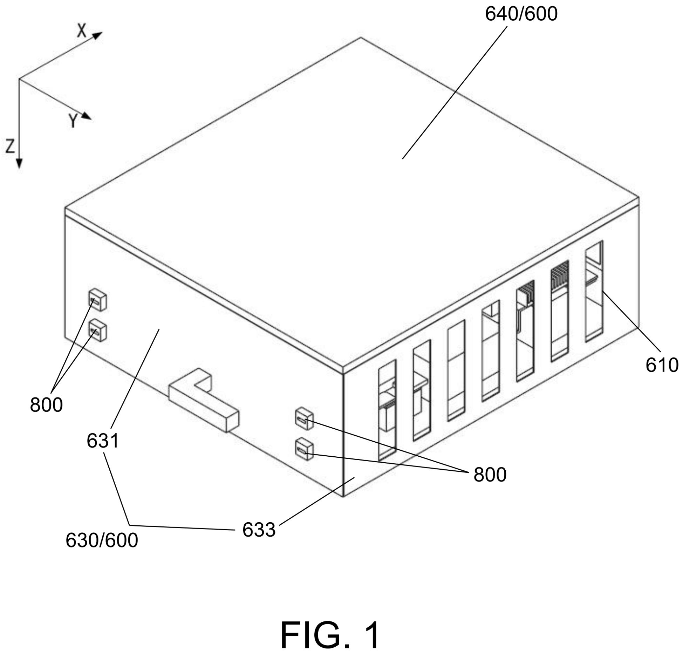

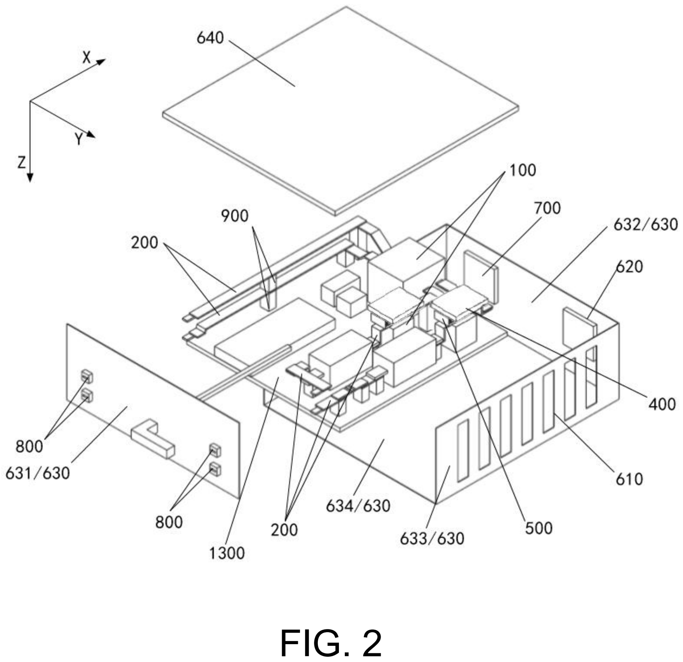

To solve the above problems, the present example provides a high-voltage box. FIG. 1 shows a perspective view of a high-voltage box with a first structure, and FIG. 2 shows an exploded view of the high-voltage box with the first structure.

As shown in FIG. 1 and FIG. 2, the high-voltage box includes a plurality of electrical components 100 and conductive components 200.

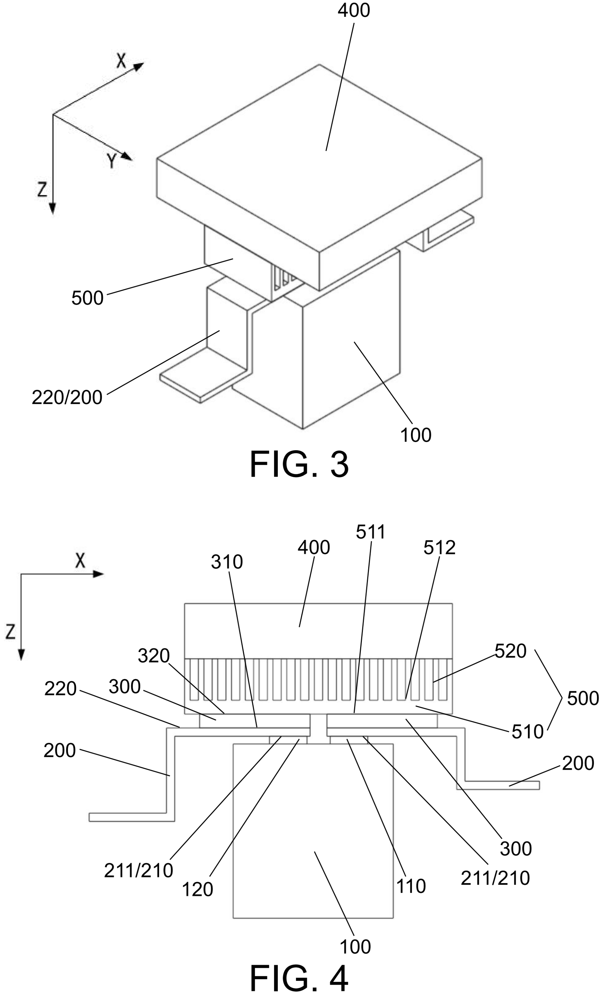

FIG. 3 is a partial perspective view of the high-voltage box. FIG. 4 is a partial side view of the high-voltage box.

As shown in FIG. 3 and FIG. 4, the conductive component 200 has a first panel surface 210 and a second panel surface 220 disposed opposite to each other along a first direction (such as the Z direction in FIG. 3 and FIG. 4). The first panel surface 210 includes a first region 211. The conductive component 200 is electrically connected to the corresponding electrical component 100 through the first region 211. A semiconductor cooling component 300 includes a cooling end 310 for absorbing heat. The cooling end 310 is thermally connected to the conductive component 200 through the second panel surface 220. Along the first direction, an orthogonal projection of the cooling end 310 on the first panel surface 210 at least partially overlaps with the first region 211.

Exemplarily, the conductive component 200 may include a conductive copper busbar or a plurality of parallel wires.

Exemplarily, electrical connections between the plurality of electrical components 100 may be achieved through the conductive components 200, and the electrical components 100 may also be electrically connected to external circuits through the conductive components 200.

Exemplarily, the first direction may be a height direction of the electrical component 100.

Exemplarily, the semiconductor cooling component 300 may be powered through the conductive component 200. Alternatively, the semiconductor cooling component 300 may be connected to a power supply through a separate electrical connection wire.

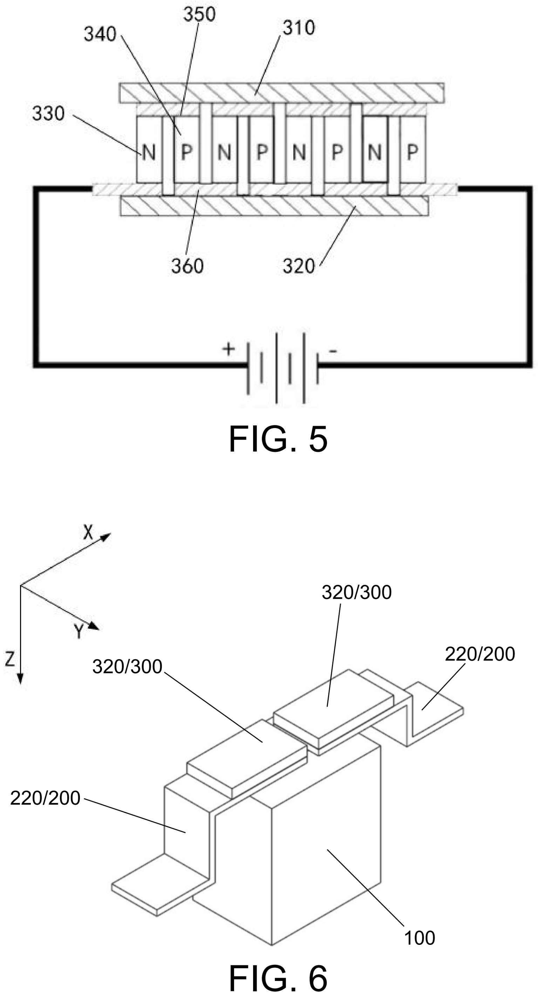

Exemplarily, the semiconductor cooling component 300 includes a semiconductor cooling panel. FIG. 5 shows a structural diagram of the semiconductor cooling panel. The semiconductor cooling panel includes a plurality of N-type semiconductor elements 330 (including bismuth telluride) and a plurality of P-type semiconductor elements 340 (including bismuth telluride). The plurality of N-type semiconductor elements 330 and the plurality of P-type semiconductor elements 340 are arranged alternately and form a series circuit with a DC power supply. Taking a thermocouple pair formed by connecting one N-type semiconductor element 330 with an adjacent P-type semiconductor element 340 as an example for explanation. After connecting DC current in the series circuit, energy transfer may be generated. Along the current direction, current flows from the N-type semiconductor element 330 through a first conductor 350 to the P-type semiconductor element 340. The first conductor 350 absorbs heat, and an insulator (for example, ceramic sheet) thermally connected to all the first conductors 350 is constructed as the cooling end 310. Similarly, current flows from the P-type semiconductor element 340 through a second conductor 360 to the N-type semiconductor element 330. The second conductor 360 releases heat, and an insulator thermally connected to all the second conductors 360 is constructed as a hot end 320. Both a heat absorption amount of the cooling end 310 and a heat release amount of the hot end 320 are related to a magnitude of the passing current and the number of thermocouple pairs formed by connecting the N-type semiconductor elements 330 and the P-type semiconductor elements 340. For example, the semiconductor cooling panel may internally include a thermoelectric stack formed by coupling hundreds of thermocouple pairs to achieve the effect of enhancing cooling (heating).

It should be illustrated that when a semiconductor heat conducting component includes a semiconductor cooling panel, a dimension of a panel surface of the semiconductor cooling panel may be selected according to a dimension of the conductive component 200 and a cooling power requirement of the electrical component 100. Moreover, it is required to ensure that the semiconductor cooling panel may be stably connected to the conductive component 200, and the dimension of the panel surface of the semiconductor cooling panel are not limited herein.

Exemplarily, when the conductive component 200 is a conductive copper busbar, the first panel surface 210 and the second panel surface 220 may be two surfaces, which are disposed opposite to each other along a thickness direction, of the conductive copper busbar. When the conductive components 200 are a plurality of parallel wires, the first panel surface 210 and the second panel surface 220 may be planes formed by fitting the plurality of wires.

Exemplarily, a surface of the cooling end 310 may be coated with a thermally conductive structural adhesive, so that the surface of the cooling end 310 is thermally connected to a surface of the conductive component 200 through the thermally conductive structural adhesive.

In this example, electrical energy may be provided or signals may be transmitted to the corresponding electrical component 100 through the conductive component 200. The applicant discovered that when the electrical component 100 in the high-voltage box operates, an electrical connection position between the electrical component 100 and the conductive component 200, that is, the first region 211 of the conductive component 200, may generate heat in a concentrated manner, causing the temperature of the first region 211 to be relatively high. In order to cool the first region 211, this example thermally connects the cooling end 310 of the semiconductor cooling component 300 to a corresponding position on the conductive component 200, so that the orthogonal projection of the cooling end 310 on the first panel surface 210 at least partially overlaps with the first region 211, that is, the cooling end 310 at least partially covers the first region 211. Based on the relatively satisfactory thermal conductive performance of the conductive component 200, the cooling end 310 may absorb heat rapidly, avoiding concentration of hot spots.

The high-voltage box provided in this embodiment, based on the semiconductor cooling component 300, offers advantages such as a compact size, a streamlined structure, lack of mechanical moving parts, minimal spatial and shape constraints, and high reliability. The design of the present disclosure allows the cooling end 310 of the semiconductor cooling component 300 to be thermally connected to the surface of the conductive component 200, ensuring that the cooling end 310 covers at least part of the first region 211 where the conductive component 200 is electrically connected to the electrical component 100. The semiconductor cooling component 300 may directly convert electrical energy into cooling energy with minimal thermal inertia, enabling rapid cooling of the conductive component 200. Such design ensures that the electrical component 100 operates safely at an appropriate temperature, contributing to the improved efficiency and stability of the high-voltage box, enhancing the overall operational efficiency of energy storage systems that include the high-voltage box, and ensuring the operational safety of the system.

As shown in FIG. 3 and FIG. 4, in some examples, the semiconductor cooling component 300 further includes the hot end 320 that dissipates heat, and the hot end 320 is thermally connected to a first active heat dissipation component 400.

Exemplarily, the first active heat dissipation component 400 may include a fan or a liquid cooling unit.

Exemplarily, the cooling end 310 and the hot end 320 are disposed opposite to each other along the first direction.

Exemplarily, the first active heat dissipation component 400 may be directly thermally connected or indirectly thermally connected to the hot end 320.

With the continuous operation of the semiconductor cooling component 300, the temperature of the hot end 320 may rise, and if heat dissipation is not performed on the hot end 320, when the temperature of the hot end 320 is too high, short circuit or open circuit of internal devices might occur in the semiconductor cooling component 300, which will cause the semiconductor cooling component 300 to be unable to operate normally.

To avoid the above situation, this example sets the first active heat dissipation component 400 at the hot end 320, and through the first active heat dissipation component 400 performing forced cooling on the hot end 320, not only that it is possible to effectively reduce the temperature of the hot end 320, but also make the temperature of the cooling end 310 correspondingly decrease, thereby achieving more rapid and effective heat dissipation for the conductive component 200. In this way, it is possible to avoid the problem of component aging and damage caused by the electrical component 100 or the conductive component 200 in the high-voltage box operating for a long time in a high-temperature environment, which enhances the service life of the electrical component 100 and the conductive component 200, and reduces maintenance and replacement frequency.

As shown in FIG. 4, in some examples, a heat dissipation component 500 is further connected between the hot end 320 and the first active heat dissipation component 400.

Exemplarily, the heat dissipation component 500 may be thermally connected to the hot end 320 through a thermally conductive structural adhesive.

Exemplarily, the first active heat dissipation component 400 may be connected to the heat dissipation component 500 through snap-fit connection, plug-in connection, or fastener connection.

Exemplarily, the heat dissipation component 500 covers the hot end 320 of the semiconductor cooling component 300 to achieve heat dissipation effect for the hot end 320 as a whole.

It should be explained that the size of a heat dissipation device may be selected according to the actual space size inside the high-voltage box and the cooling power of the semiconductor cooling component 300, which is not limited herein.

When the temperature of the hot end 320 increases, the heat dissipation component 500 may absorb the heat of the hot end 320, and under the combined action of natural wind and the first active heat dissipation component 400, rapidly disperse the heat of the heat dissipation component 500 itself to quickly reduce the temperature of the heat dissipation component 500, thereby enabling the heat dissipation component 500 to continue absorbing the heat of the hot end 320, and so on in cycles. In this way, it is possible to achieve more efficient heat dissipation for the hot end 320 of the semiconductor cooling component 300 through the heat dissipation component 500 and the first active heat dissipation component 400, ensuring that the electrical component 100 and the conductive component 200 in the high-voltage box may operate safely and stably.

As shown in FIG. 4, in some examples, the heat dissipation component 500 includes a heat conducting body 510 and a plurality of heat dissipation fins 520. The heat conducting body 510 has a first heat conducting surface 511 and a second heat conducting surface 512. The first heat conducting surface 511 is thermally connected to the hot end 320. The plurality of heat dissipation fins 520 are thermally connected to the second heat conducting surface 512 arranged at intervals. The first active heat dissipation component 400 is connected to a side of the heat dissipation fin 520 away from the second heat conducting surface 512.

Exemplarily, the first heat conducting surface 511 and the second heat conducting surface 512 may be disposed adjacent to or opposite to each other.

Exemplarily, the heat conducting body 510 is a panel-like structure. One panel surface of the panel-like structure may serve as the first heat conducting surface 511, and the corresponding other panel surface may serve as the second heat conducting surface 512.

Exemplarily, a method of connecting the heat dissipation fin 520 and the heat conducting body 510 may be welding, bonding, fastener connection or integral molding connection.

By connecting the plurality of heat dissipation fins 520 on the heat conducting body 510, it is possible to increase a surface area of the heat conducting body 510, so that air flowing between two of the adjacent heat dissipation fins 520 may carry away more heat, which enhances the heat dissipation effect for the hot end 320.

Meanwhile, by connecting the first active heat dissipation component 400 to a side of the heat dissipation fin 520 away from the second heat conducting surface 512, that is, by connecting the first active heat dissipation component 400 to a free end of the heat dissipation fin 520, an air flow speed between two of the adjacent heat dissipation fins 520 may be improved through the first active heat dissipation component 400 (when the first active heat dissipation component 400 is a fan), or a medium temperature between two of the adjacent heat dissipation fins 520 may be reduced (when the first active heat dissipation component 400 is a liquid cooling component), which further contributes to the heat dissipation effect for the hot end 320.

FIG. 6 shows a schematic diagram of FIG. 3 after removing the first active heat dissipation component 400 and the heat dissipation component 500. As shown in FIG. 4 and FIG. 6, in some embodiments, when at least two of the hot ends 320 have surfaces that are adjacent to each other and located on the same plane, at least two of the surfaces are thermally connected to the same first heat conducting surface 511.

Exemplarily, a surface connected with the first heat conducting surface 511 is a surface of the hot end 320 away from the cooling end 310.

Taking the structure and direction shown in FIG. 4 as an example for illustration, the electrical component 100 includes an input terminal 110 and an output terminal 120. Both the input terminal 110 and the output terminal 120 are located at the top of the electrical component 100 and are adjacent to each other. The input terminal 110 and the output terminal 120 are each connected with the conductive component 200, and each of the conductive components 200 is connected with the semiconductor cooling component 300. Based on a positional relationship between the input terminal 110 and the output terminal 120, correspondingly, surfaces of the respective hot ends 320 of the two semiconductor cooling components 300 are adjacent to each other and located on the same plane. Under the circumstances, the respective hot ends 320 of the two semiconductor cooling components 300 may be thermally connected simultaneously through the same heat dissipation component 500, so as to dissipate heat for the two hot ends 320 through the same heat dissipation component 500 and the same first active heat dissipation component 400. Such design not only enhances reducing the preparation cost of the high-voltage box, but also may avoid the problem of mutual interference between the adjacent heat dissipation components 500 or the adjacent first active heat dissipation components 400 due to the small gap space between the adjacent semiconductor cooling components 300.

As shown in FIG. 4, in some examples, along the first direction, the orthogonal projection of the cooling end 310 on the first panel surface 210 covers the first region 211.

The cooling end 310 provides comprehensive coverage for the first region 211, which on one hand enhances the cooling efficiency and cooling effect of the semiconductor cooling component 300 for the electrically connected part of the conductive component 200 and the electrical component 100, and on the other hand may also make the temperature at various positions of the first region 211 more uniform, which contributes to enhancement of the temperature consistency of the electrical connection part of the electrical component 100.

It should be explained that, in the examples of the present disclosure, the installation position of the semiconductor cooling component 300 may be designed according to the actual heat generation situation and space distribution in the high-voltage box. In addition to connecting the semiconductor cooling component 300 to the conductive component 200, the semiconductor cooling component 300 may also be directly connected to the electrical component 100 with overheating risks.

In some examples, the cooling end 310 is thermally connected to at least a partial region of the surface of the target electrical component 100.

Exemplarily, the target electrical component is the electrical component 100 that is prone to overload and overheating situations in high-temperature environments.

Generally, the housing of the electrical component 100 that requires heat dissipation has specific thermal conductive performance. Thermally connecting the cooling end 310 of the semiconductor cooling component 300 to the surface of the target electrical component 100 may achieve precise heat dissipation for the respective electrical components 100 in the high-voltage box according to the heat dissipation requirements of different electrical components 100, thereby accurately and effectively controlling the temperature of the respective electrical components 100 in the high-voltage box, so as to improve the heat dissipation efficiency and operational stability of the high-voltage box.

As shown in FIG. 1, FIG. 2 and FIG. 4, in some examples, the high-voltage box includes a housing 600. The electrical component 100, the conductive component 200, and the semiconductor cooling component 300 are disposed in the housing 600. A side wall of the housing 600 is provided a through ventilation hole 610 and/or a mounting through hole 620. A second active heat dissipation component 700 is connected in the mounting through hole 620. The conductive component 200 is close to the side wall of the housing 600 and extends along the side wall of the housing 600.

Exemplarily, one, two or multiple ventilation holes 610 may be provided. When the multiple ventilation holes 610 are provided, the multiple ventilation holes 610 may be distributed in an array or unidirectionally spaced on the side wall of the housing 600, so as to improve a flow rate and a flow volume of air entering or flowing out of the high-voltage box through the ventilation holes 610, so as to improve the heat dissipation efficiency of the high-voltage box.

Exemplarily, the housing 600 includes a lower casing 630 and an upper cover 640. The lower casing 630 includes a panel 631 and a back panel 632 disposed opposite to each other along a second direction (such as the X direction in FIG. 2), two side panels 633 disposed opposite to each other along a third direction (such as the Y direction in FIG. 2), and a bottom panel 634. The panel 631, the back panel 632 and the two side panels 633 are enclosed to form a frame structure. The bottom panel 634 blocks a bottom opening of the frame structure and is fixedly connected with the frame structure, and the upper cover 640 covers a top opening of the frame structure.

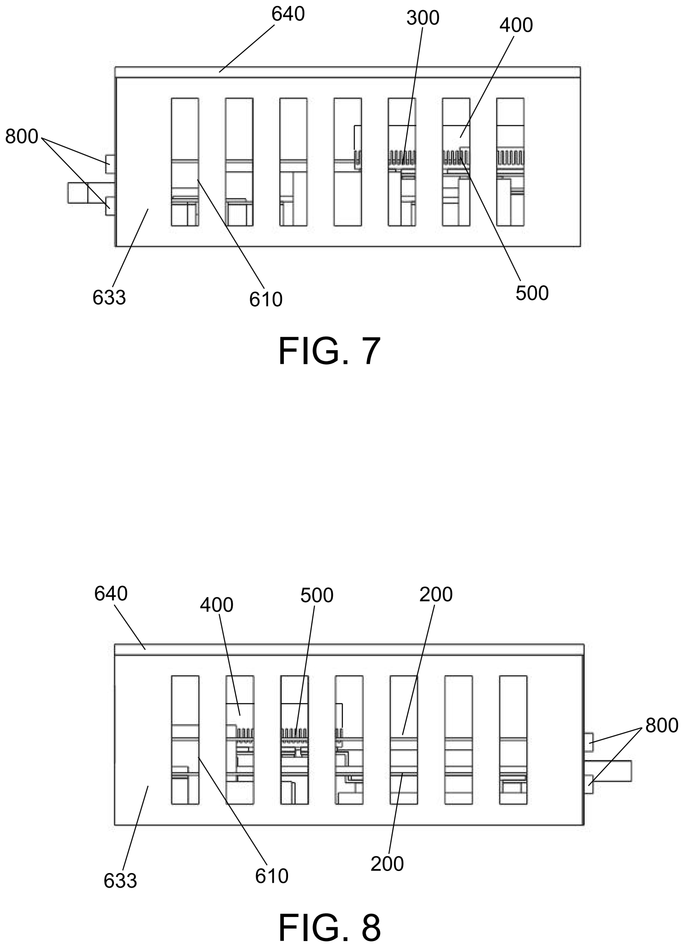

Exemplarily, FIG. 7 is a right-side view of a high-voltage box. FIG. 8 is a left-side view of a high-voltage box. As shown in FIG. 7 and FIG. 8, each of the side panels 633 is provided with the multiple ventilation holes 610, and the multiple ventilation holes 610 are spaced along the second direction.

Exemplarily, the ventilation hole 610 is a rectangular hole.

Exemplarily, two second active heat dissipation components 700 are provided and spaced apart on the back panel 632 along the third direction.

Exemplarily, the first active heat dissipation component 400 and the second active heat dissipation component 700 may be the same or different.

Through the ventilation holes 610, air may flow between the high-voltage box and the outside, which enhances the dispersion of high-temperature air inside the high-voltage box to the outside, so as to improve the heat dissipation efficiency of the high-voltage box. Through the second active heat dissipation component 700, the flow speed of air between the high-voltage box and the outside may be improved, or the temperature of the flowing air may be reduced, which contributes to further improvement of the heat dissipation effect of the high-voltage box.

Meanwhile, the conductive component 200 is close to the side wall of the housing 600, which may shorten a distance between the conductive component 200 and the ventilation hole 610 or the second active heat dissipation component 700, so as to improve the heat dissipation effect of the ventilation hole 610 or the second active heat dissipation component 700 on the conductive component 200 and the heat dissipation component 500, and improve the speed of releasing heat by the conductive component 200 or the heat dissipation component 500.

As shown in FIG. 2, in some embodiments, at least part of the conductive component 200 is provided with at least two stacked layers arranged at intervals along the first direction. An insulating support component 900 is disposed between the conductive components 200 adjacent to each other along the first direction.

Exemplarily, the insulating support component 900 may be a columnar structure or a block structure.

Exemplarily, according to an extension length of the conductive component 200, one, two or multiple insulating support components 900 may be provided along the extension direction of the conductive component 200, so that a preset distance may be maintained between the stacked and adjacent conductive components 200, thereby ensuring that spatial insulation may be achieved between the stacked and adjacent conductive components 200.

When multiple conductive components 200 need to be provided, the multiple conductive components 200 may be stacked along the first direction, so as to enable each of the conductive components 200 to be close to the ventilation holes 610 or the second active heat dissipation component 700 on the side panel 633, so that the ventilation hole 610 or the second active heat dissipation component 700 may achieve a better heat dissipation effect on the multiple conductive components 200. The stacked multiple conductive components 200 may be spaced apart from each other through the insulating support component 900, so as to avoid overlap or arcing between the adjacent conductive components 200, thus ensuring that adjacent conductive components 200 achieve a better insulation effect, and ensuring that the electrical component 100 in the high-voltage box may operate normally.

In some embodiments, at least one of the first active heat dissipation component 400 and the second active heat dissipation component 700 includes a fan.

The advantages of fans include high heat dissipation capability, reliable operation, convenient installation and low cost. Using the fan as the first active heat dissipation component 400 and/or the second active heat dissipation component 700 helps to improve the operational stability of the high-voltage box, reduce the assembly difficulty and material cost of the high-voltage box, and helps batch production.

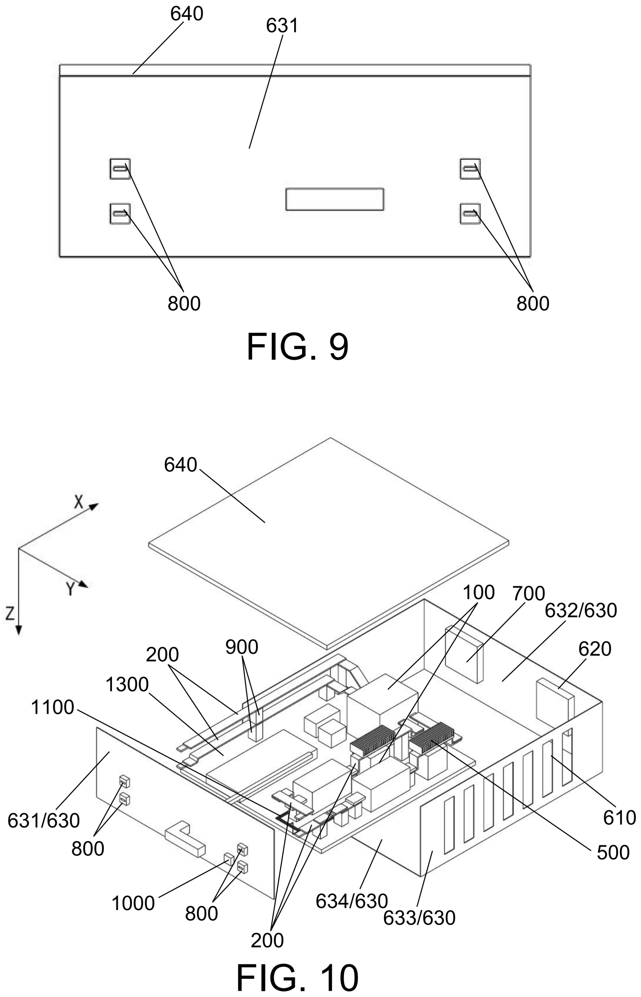

FIG. 9 shows a front view of the panel 631 of the first structure. As shown in FIG. 9, in some embodiments, multiple electrical interfaces 800 are connected to the panel 631 of the housing 600, and the conductive components 200 are electrically connected with the corresponding electrical interfaces 800.

Exemplarily, the electrical interface 800 is embedded in the panel 631. One end of the electrical interface 800 is located inside the housing 600 and electrically connected with the conductive component 200; the other opposite end of the electrical interface 800 is located outside the housing 600 and configured for electrically connecting with external circuits.

The conductive component 200 may be electrically connected with external circuits through the electrical interface 800 disposed on the panel 631, so that the conductive component 200 may supply power to or transmit signals to the electrical component 100 in the housing 600.

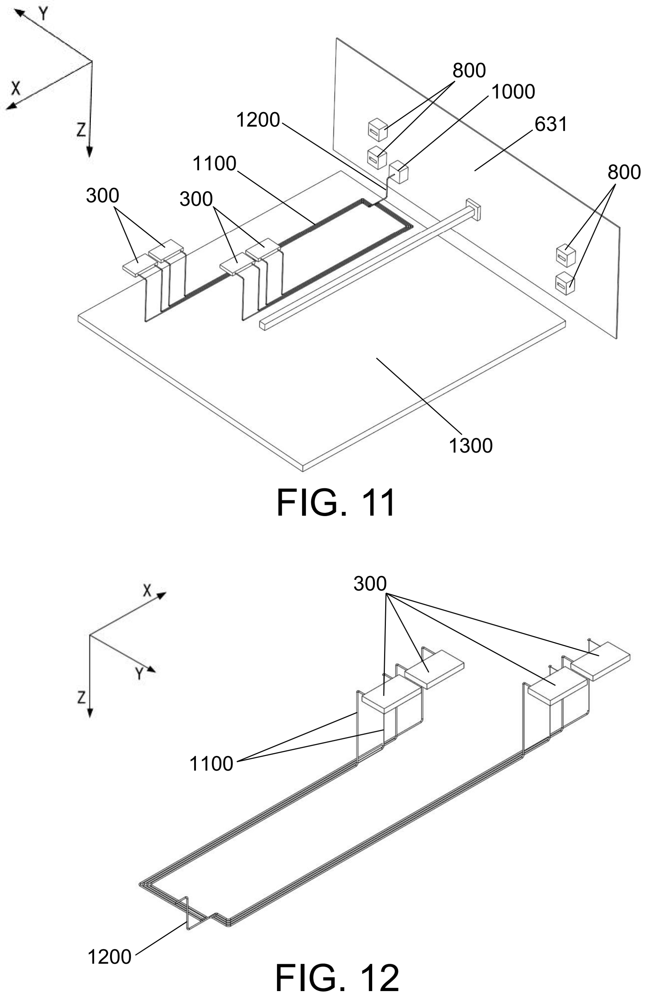

FIG. 10 is an exploded perspective view of a high-voltage box with a second structure. FIG. 11 is a rear perspective view of the panel 631 of the high-voltage box with the second structure. As shown in FIG. 10 and FIG. 11, in some embodiments, the panel 631 is further connected with a cooling electrical interface 1000, and the semiconductor cooling component 300 is electrically connected with the cooling electrical interface 1000.

Exemplarily, as shown in FIG. 10 and FIG. 11, the cooling electrical interface 1000 is embedded in the panel 631. One end of the cooling electrical interface 1000 is located inside the housing 600 and electrically connected with the semiconductor cooling component 300 through a cooling wire 1100; the other opposite end of the cooling electrical interface 1000 is located outside the housing 600 and configured for electrically connecting with external circuits.

Exemplarily, FIG. 12 is a diagram showing a connection between the semiconductor cooling component 300 and the cooling wire 1100. Each of the semiconductor cooling components 300 leads to two cooling wires 1100, and multiple cooling wires 1100 may be simultaneously connected to the same cooling main wire 1200 after extending to a position close to the panel 631, and electrically connected with the cooling electrical interface 1000 through the cooling main wire 1200.

Through the cooling electrical interface 1000 on the panel 631, the semiconductor cooling component 300 may be separately powered or have its power regulated, so that the semiconductor cooling component 300 may stably cool the electrical component 100 in the high-voltage box. Moreover, by regulating the power of the semiconductor cooling component 300, the temperature of the electrical component 100 and the conductive component 200 may be controlled more precisely, so that the electrical component 100 may operate stably within a preset temperature range, which enhances the working efficiency and stability of the high-voltage box, and extends the operation time.

In some embodiments, the conductive component 200 includes a solid structure formed by a conductive material.

Designing the conductive component 200 as a solid structure helps to increase a current-carrying area of the conductive component 200, so that the conductive component 200 may have a higher conductive ability under the same surface area. Meanwhile, since conductive materials typically have a good heat conducting ability, designing the conductive component 200 as a solid structure formed by the conductive material may also ensure that the conductive component 200 has a good heat conducting ability, which enhances the heat dissipating effect of the semiconductor cooling component 300 on the electrical component 100 and the conductive component 200.

In some embodiments, the electrical component 100 includes at least one of a pre-charge resistor, a pre-charge relay, a fuse, a high-voltage relay, a switching-mode power supply relay, a switching-mode power supply, an isolation switch, a current sensor, and a shunt.

Exemplarily, the multiple electrical components 100 may be connected to at least one circuit board 1300, the conductive component 200 may be disposed above the circuit board 1300, and separated from the circuit board 1300 through the insulating support component 900.

It should be explained that the electrical component 100 and its connection structure in the high-voltage box may be selected and designed according to the functional requirements of the high-voltage box, which are not limited herein.

Based on the same inventive concept, in combination with the description of the high-voltage box of the above various embodiments, this embodiment provides an energy storage container. The energy storage container has corresponding technical effects of the high-voltage box in the above various embodiments, which will not be described redundantly herein.

An energy storage container includes an energy storage cluster (or called battery cluster), an energy storage converter (PCS), and the high-voltage box as described in the above various embodiments. The high-voltage box is electrically connected to the energy storage cluster and the energy storage converter respectively.

The high-voltage box serves as a high-voltage circuit management module connecting the energy storage cluster and the energy storage converter, and has functions of energy storage cluster voltage/current collection, contactor control and protection and so on.

It should be explained that some embodiments of the present disclosure have been described above. Other embodiments are within the scope of the appended claims.

Each embodiment in the present disclosure is described in a progressive manner, each embodiment focuses on illustrating the differences from other embodiments, and the same or similar parts between the various embodiments may serve as cross-reference for each other.

## Claims

1. A high-voltage box, comprising:
a plurality of electrical components (100);
a plurality of conductive components (200), each of the plurality of conductive components (200) having a first panel surface (210) and a second panel surface (220) disposed opposite to each other along a first direction, wherein the first panel surface (210) comprises a first region (211), each of the plurality of conductive components (200) is electrically connected with the respective one of the plurality of electrical components (100) through the first region (211);
a plurality of semiconductor cooling components (300), each of the plurality of semiconductor cooling components (300) comprising a cooling end (310) for absorbing heat, wherein the cooling ends (310) are thermally connected with the plurality of conductive components (200) through the second panel surfaces (220);
along the first direction, an orthogonal projection of each of the cooling ends (310) on the corresponding first panel surface (210) at least partially overlaps with of the first region (211).

2. The high-voltage box according to claim 1, wherein each of the plurality of semiconductor cooling components (300) further comprises a hot end (320) for dissipating heat, the hot end (320) is thermally connected with a first active heat dissipation component (400).

3. The high-voltage box according to claim 2, wherein a heat dissipation component (500) is further connected between each of the hot ends (320) and the corresponding first active heat dissipation component (400).

4. The high-voltage box according to claim 3, wherein each of the heat dissipation components (500) comprises a heat conducting body (510) and a plurality of heat dissipation fins (520), the heat conducting body (510) has a first heat conducting surface (511) and a second heat conducting surface (512), the first heat conducting surface (511) is thermally connected with the hot end (320), the plurality of heat dissipation fins (520) are thermally connected to the second heat conducting surface (512) arranged at intervals;
each of the first active heat dissipation components (400) is connected to a side of the respective one of the plurality of heat dissipation fins (520) away from the second heat conducting surface (512).

5. The high-voltage box according to claim 4, wherein when at least two of the hot ends (320) have surfaces that are adjacent to each other and located on the same plane, at least two of the surfaces are thermally connected to the same first heat conducting surface (511).

6. The high-voltage box according to claim 1, wherein along the first direction, the orthogonal projection of each of the cooling ends (310) on the corresponding first panel surface (210) covers the first region (211).

7. The high-voltage box according to claim 1, wherein at least part of the plurality of conductive components (200) are provided with at least two stacked layers arranged at intervals along the first direction, an insulating support component (900) is disposed between two of the plurality of conductive components (200) adjacent to each other along the first direction.

8. The high-voltage box according to claim 1, wherein the high-voltage box comprises a housing (600), and the plurality of electrical components (100), the plurality of conductive components (200), and the plurality of semiconductor cooling components (300) are disposed within the housing (600);
a side wall of the housing is provided with a through ventilation hole (610) and a mounting through hole (620), a second active heat dissipation component (700) is connected in the mounting through hole (620), at least one of the plurality of conductive components (200) is close to the side wall of the housing (600) and extend along the side wall of the housing (600).

9. The high-voltage box according to claim 8, wherein the high-voltage box comprises a first active heat dissipation component (400), at least one of the first active heat dissipation component (400) and the second active heat dissipation component (700) comprises a fan.

10. The high-voltage box according to claim 1, wherein the high-voltage box comprises a housing (600), the housing (600) comprises a panel (631), the panel (631) is connected with a plurality of electrical interfaces (800), each of the plurality of conductive components (200) is electrically connected with the respective one of the plurality of electrical interfaces (800);
the panel (631) is further connected with at least one cooling electrical interface (1000), the plurality of semiconductor cooling components (300) are electrically connected with the at least one cooling electrical interface (1000).

11. The high-voltage box according to claim 1, wherein the plurality of conductive components (200) comprise a solid structure formed by a conductive material.

12. The high-voltage box according to claim 1, wherein each of the plurality of electrical components (100) comprises at least one of a pre-charge resistor, a pre-charge relay, a fuse, a high-voltage relay, a switching-mode power supply relay, a switching-mode power supply, an isolation switch, a current sensor, and a shunt.

13. An energy storage container, comprising an energy storage cluster, an energy storage converter, and the high-voltage box according to any one of claims 1-12, wherein the high-voltage box is electrically connected with the energy storage cluster and the energy storage converter respectively.
